# EUROPEAN PATENT APPLICATION

(11) **EP 1 652 966 A2**
(43) Date of publication of application: **03.05.2006**
(21) Application number: 05023430.1
(22) Date of filing: 26.10.2005
(51) Int. Cl.: C23C 30/00, C23C 14/06, F16C 33/00

(54) **Hard-carbon coated sliding member**

(30) Priority: 01.11.2004 JP 2004317513; 25.03.2005 JP 2005088270
(71) Applicant: NISSAN MOTOR CO., LTD., Yokohama-shi, Kanagawa 221-0023 (JP); Miyake, Shojiro, Hamura-shi, Tokyo 205-0011 (JP)
(72) Inventor: Okamoto, Yusuke, Yokohama-shi Kanagawa 245-0061 (JP); Yasuda, Yoshiteru, Yokohama-shi Kanagawa 236-0012 (JP); Miyake, Shojiro, Hamura-shi Tokyo 205-0011 (JP)
(74) Representative: Grünecker, Kinkeldey, Stockmair & Schwanhäusser Anwaltssozietät

(57) **Abstract**

There is provided a sliding member including a base substrate and a hard carbon coating formed on the base substrate to define at least a surface for sliding contact with an opposing member. The hard carbon coating contains therein at least one of cobalt and nickel in an amount of 1.4 to 39 atomic%.

## Description

### BACKGROUND OF THE INVENTION

The present invention relates to a sliding member having a hard carbon coating to show excellent low-friction sliding characteristics, particularly of the kind suitable for use with a lubricating oil such as an automotive engine oil or transmission oil.

A hard carbon coating is formed of amorphous carbon-based material such as amorphous carbon or hydrogen-containing amorphous carbon (a-C:H), *i*-carbon (*i*-C), diamond-like carbon (DLC) or the like. For the formation of this hard carbon coating, a vapor phase reaction process is often used including plasma chemical vapor deposition (CVD) in which the hard carbon coating is deposited by the plasma decomposition of hydrocarbon gas and ion beam vapor deposition process which the hard carbon coating is deposited by a beam of carbon or hydrocarbon ions.

It is well known that the hard carbon coating has not only a high hardness, surface smoothness, high wear resistance but also a low friction coefficient due to its solid lubrication properties. The friction coefficient of the hard carbon coating is about 0.1 under dry conditions, whereas the friction coefficient of a smoothly surfaced steel material is normally in a range of 0.5 to 1.0 under dry conditions. The hard carbon coating thus shows excellent sliding characteristics and are adapted to various applications such as working tools e.g. cutting/grinding tools (including drill blades), plastic forming dies and sliding parts e.g. valve cocks and capstan rollers used under dry conditions.

On the other hand, there is a demand to reduce a mechanical loss between machine parts of an internal combustion engine etc. slidably movable under lubrication conditions. The application of the above-mentioned hard carbon coating to such a sliding part, notably used under extreme sliding conditions that can cause a large frictional loss, has been thus examined by making some attempts to control the composition and surface condition of the hard carbon coating in such a manner that the hard carbon coating achieves a low friction coefficient not only under dry conditions but also under lubricated conditions.

For instance, Japanese Laid-Open Patent Publication No. 2003-247060 (herein abbreviated as "JP2003-247060A") proposes doping at least one of IVa-, Va- and VIa-group elements and silicon (Si) element into a hard carbon coating. The hard carbon coating of JP2003-247060A shows a friction coefficient of 0.06, which is lower than that of a hard carbon coating free of the above doping elements, as measured by a so-called motoring wear test.

Japanese Laid-Open Patent Publication No. 2004-099963 (abbreviated to as "JP2004-099963A") proposes adding silver (Ag) clusters to a hard carbon coating. The hard carbon coating of JP2004-099963A shows a minimum friction coefficient of 0.04 as measured by a so-called reciprocating wear test.

Japanese Laid-Open Patent Publication No. 2004-115826 (abbreviated as "JP2004-115826A") proposes not only doping at least one of IIb-, III-, IV-, Va-, VIa-, VIIa and VIII-group elements into a hard carbon coating but also controlling the oxygen content of the hard carbon coating so that the hard carbon coating can attain a low friction coefficient.

In the case of using such a hard-carbon coated sliding part, there is also a demand to prevent abrasion and wear in its opposing sliding part.

Japanese Laid-Open Patent Publication No. 2003-027214 (abbreviated to as "JP2003-027214A") proposes, in response to the above demand, forming a hard carbon coating on a sliding part in such a manner that the hard carbon coating has a surface portion made of relatively soft hydrogen-containing amorphous carbon and doped with any of vanadium (V), chromium (Cr), zirconium (Zr), niobium (Nb), tantalum (Ta), molybdenum (Mo), tungsten (W), palladium (Pd), platinum (Pt), titanium (Ti), aluminum (Al), lead (Pb) and silicon (Si) elements.

### SUMMARY OF THE INVENTION

Regardless of the difference in measurement methods, it is desired that the friction coefficients of the hard carbon coatings of JP2003-247060A and JP2004-099963A be further lowered. In addition, the process of forming the hard carbon coating of JP2004-099963A is complicated since the size and number of the silver clusters on the hard carbon coating needs to be controlled during coating formation. The process of forming the hard carbon coating of JP2004-115826A is also complicated since both of the metal content and the oxygen content of the hard carbon coating need to be controlled during coating formation. The simplification of these hard carbon coating formation processes is thus desired. Further, the hard carbon coating of JP2004-115826A shows a relatively low friction coefficient only when used with a lubricating oil containing an extreme-pressure agent such as molybdenum dithiocarbamate (MoDTC) so that there are restrictions on the kind of lubricating oil used for lubrication of the hard carbon coating. Although the friction coefficient of the hard carbon coating of JP2003-027214A can be lowered by the addition of the above-specified metal element or elements, such a friction coefficient lowering effect is limited due to the fact that the hydrogen-containing hard carbon coating is originally higher in friction coefficient than a substantially hydrogen-free hard carbon coating (e.g. of Japanese Laid-Open Patent Publication No. 2000-297373) under lubrication conditions.

It is therefore an object of the present invention to provide a sliding member having a hard carbon coating capable of being formed by a simple process and used with fewer restrictions on the kind of lubricating oil to show a sufficiently low friction coefficient.

It is also an object of the present invention to provide a sliding member having a substantially hydrogen-free hard carbon coating capable of preventing abrasion and wear in an opposing sliding member.

According to one aspect of the present invention, there is provided a sliding member, comprising: a base substrate; and a hard carbon coating formed on the base substrate to define at least a surface for sliding contact with an opposing sliding member, the hard carbon coating containing therein at least one of cobalt and nickel in an amount of 1.4 to 39 atomic%.

According to another aspect of the present invention, there is provided a sliding member, comprising: a base substrate; and a hard carbon coating formed on the base substrate to define at least a surface for sliding contact with an opposing member, wherein at least a surface portion of the hard carbon coating comprises 1.4 to 39 atomic% of either or both of cobalt and nickel, 6 atomic% or less of hydrogen and the balance being carbon.

The other objects and features of the present invention will also become understood from the following description.

### BRIEF DESCRIPTION OF THE DRAWING

FIG. 1 is a section view of part of a sliding member according to one exemplary embodiment of the present invention.

FIG. 2 is a schematic view showing how a sliding mark is caused under a ball-on-disk test.

### DESCRIPTION OF THE EMBODIMENT

As a result of extensive researches on various kinds and formation processes of hard carbon coatings and metal doping effects on hard carbon coatings, it has been found by the present inventors that the doping of at least one of cobalt (Co) and nickel (Ni) in a hard carbon coating is effective in lowering a friction coefficient and abrasiveness of the hard carbon coating. The present invention is based on such a finding.

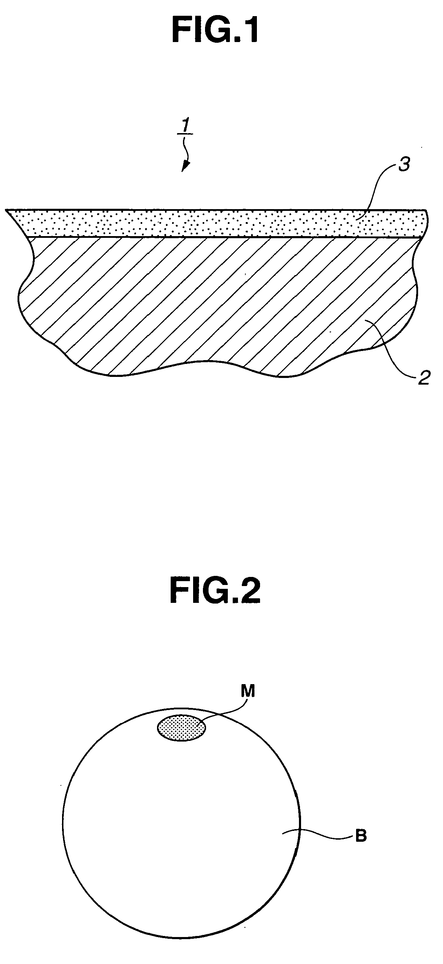

As shown in FIG. 1, a sliding member 1 according to an embodiment of the present invention includes a base substrate 2 and a hard carbon coating 3 formed on the base substrate 2 to define at least a surface for sliding contact with an opposing member.

The material of the base substrate 2 is not particularly restricted. The base substrate 2 can be made of e.g. a metal or metal alloy material.

The hard carbon coating 3 is mainly composed of carbon and contains therein at least one of cobalt and nickel.

Although the hard-carbon coated sliding member 1 can be used under either dry conditions or lubricated conditions, it is desirable to use the sliding member 1 under lubrication conditions where the sliding contact surface of the hard carbon coating 2 is lubricated with a lubricating oil in order to obtain a maximum friction reducing effect on the hard carbon coating 2. As the lubricating oil, there may be suitably used a commercially available automotive engine oil or transmission oil.

The mechanism of improvement of the sliding characteristics (such as friction coefficient and abrasiveness) of the hard carbon coating 3 is herein estimated as follows.

The doping of cobalt and/or nickel in the hard carbon coating 3 promotes adsorption of a base oil component and additive components of the lubricating oil to form a thin lubricating oil film on the sliding contact surface of the hard carbon coating 3 and thereby prevent direct contact of the hard carbon coating 3 with the opposing member even under boundary lubrication conditions of high surface pressure and low sliding speed. The hard carbon coating 3 becomes thus able to attain a low fiction coefficient. Further, the doping of cobalt and/or nickel in the hard carbon coating 3 causes some changes in chemical structure and thickness of the hard carbon coating 3 to produce a favorable effect that the hard carbon coating 3 becomes less likely to abrade or wear away the opposing member.

The sliding characteristics of the hard carbon coating 3 can be maximized by controlling the total amount of cobalt and/or nickel contained in the hard carbon coating 3 to within specific limits. In the present embodiment, the amount of cobalt and/or nickel contained in the hard carbon coating 3 is preferably controlled to within a range of 1.4 to 39 atomic%. When the cobalt and/or nickel amount of the hard carbon coating 3 is less than 1.4 atomic%, the above lubricating oil adsorption effect of the hard carbon coating 3 cannot be obtained sufficiently. In order for the hard carbon coating 3 to obtain a sufficient lubricating oil adsorption effect, the cobalt and/or nickel amount of the hard carbon coating 3 is more preferably controlled to 3 atomic% or more, still more preferably 6 atomic% or more. It is now concluded that the presence of cobalt and/or nickel atoms disturbs the network structure of carbon atoms in the hard carbon coating 3 and thereby causes deteriorations in the hardness and low-friction characteristics of the hard carbon coating 3 when the cobalt and/or nickel amount of the hard carbon coating exceeds 39 atomic%. The cobalt and/or nickel amount of the hard carbon coating 3 is more preferably controlled to 20 atomic% or less, still more preferably 16 atomic% or less.

The hard carbon coating 3 does not necessarily ensure a uniform content of cobalt and/or nickel from the coating surface to the depth. It is possible to obtain sufficient improves in the sliding characteristics of the hard carbon coating 3 by doping cobalt and/or nickel into at least a wear allowance i.e. an outermost surface portion of the hard carbon coating 3 on and below the sliding contact surface that may be abraded or worn away during the sliding between the sliding member 1 and the opposing member.

In order to further improve the sliding characteristics of the hard carbon coating 3, the amount of hydrogen contained in the hard carbon coating 3 is desirably controlled to 6 at% or less, more desirably 1 at% or less. It is concluded that the additive components of the lubricating oil becomes more likely to be adsorbed onto the hard carbon coating 3 as the hydrogen amount of the hard carbon coating 3 decreases.

The hard carbon coating 3 having such a low-hydrogen content can be formed by a physical vapor deposition (PVD) process e.g. a sputtering process or an ion plating process that does not use hydrogen gases or hydrogen-containing compounds in its process atmosphere.

In this way, it is possible according to the present embodiment to lower the friction coefficient and abrasiveness of the hard carbon coating 3, by doping the optimally controlled amount of cobalt and/or nickel in the hard carbon coating 3, especially when used with the lubricating oil.

The present invention will be described in more detail with reference to the following examples. It should be however noted that the following examples are only illustrative and not intended to limit the invention thereto.

### Example 1

A disk plate of carburized steel SCM415 (according to JIS G 4105) having a diameter of 30 mm and a thickness of 3 mm was prepared as a base substrate. A surface of the disk plate was superfinished to an arithmetic mean roughness Ra of 0.020 µm (according to JIS B 0601). A hard carbon coating was formed on the superfinished surface of the disk plate by magnetron sputtering in an atmosphere of argon gas. In the magnetron sputtering, a graphite disk plate was uses as a target. In order to dope a certain amount of cobalt in the hard carbon coating, a sector cobalt plate was attached onto the graphite disk target. The graphite disk target had a radius of 80 mm, whereas the sector cobalt plate had a radius of 80 mm and a vertex angle of 7.5° to cover 1/48 of the graphite target. In advance of the formation of the hard carbon coating on the steel disk plate, a coating growth rate was determined by performing magnetron sputtering under the same conditions as above except that only a graphite disk plate was used as a sputtering target (without a cobalt plate). The sputtering time was controlled according to the coating growth rate in such a manner as to adjust the thickness of the hard carbon coating to 1.0 ± 0.3 µm.

The thus-obtained hard carbon coating was tested for its surface roughness. The arithmetic mean surface roughness Ra of the hard carbon coating was 0.024 µm in Example 1.

Next, the hard carbon coating was tested for its chemical composition. The metal content of the hard carbon coating was measured by X-ray photoelectron spectroscopy (XPS). Considering the adsorption of impurities on the outermost surface of the hard carbon coating, the content of metal in the hard carbon coating at a depth of 3 nm below the coating surface was used as a typical value. The cobalt content of the hard carbon coating was 19 atomic% in Example 1. The hydrogen content of the hard carbon coating was measured by secondary ion mass spectrometry (SIMS). The measurement was made to a depth of 5 nm below the coating surface, and the content of hydrogen in the hard carbon coating at a depth of 3 nm below the coating surface was used as a typical value. The hydrogen content of the hard carbon coating was 0.1 atomic% or less in Example 1.

The hard-carbon coated disk plate was then subjected to a so-called ball-on-disk test in order to evaluate the friction characteristics of the hard carbon coating of the disk plate. The ball-on-disk test was conducted by turning the hard-carbon coated disk plate against an opposing member under the following conditions, with the opposing member held by an arm under a vertical load and thereby prevented from rolling during the test.

**[Friction Coefficient Measurement Conditions]**

| | |
|---|---|
| Opposing member: | Ball of bearing steel SUJ2 (according to JIS G 4805) having a diameter of 6 mm, |
| Rotation radius: | 4 mm |
| Sliding speed: | 2.4 cm/sec |
| Vertical load: | 10 N |
| Lubricating oil: | Automotive engine oil 5W-30 SL |
| Oil temperature: | 80°C |

In view of the adaptability of the hard-carbon coated disk plate and the opposing member via the lubricating oil after the start of the test, the measurement value of the torque exerted on the arm after a lapse of 5 minutes from the test start was taken as the friction coefficient of the hard carbon coating. The friction coefficient of the hard carbon coating was 0.022 in Example 1. After the friction coefficient measurement, the ball-on-disk test was further made for 120 minutes under the same conditions as above except that the vertical load on the opposing member was increased to 40 N. During the sliding between the hard-carbon coated disk plate and the opposing member, there occurred a nearly circular sliding mark (M) in the opposing member (B) as shown in FIG. 2. The diameter of such a sliding mark was taken as the amount of abrasion and wear caused in the opposing member. It should be noted that a smaller sliding mark diameter naturally meant a smaller amount of abrasion and wear in the opposing member and a lower abrasiveness of the hard carbon coating. The sliding mark of the opposing member was 40 µm in diameter in Example 1.

The coating formation conditions and evaluation test results of Example 1 are summarized in TABLE.

### Example 2

A hard-carbon coated disk plate was prepared in the same way as in Example 1, except that a hard carbon coating of the disk plate was formed by magnetron sputtering with a sector nickel plate being attached onto a graphite disk target to dope a certain amount of nickel into the hard carbon coating. The graphite disk target had a radius of 80 mm, whereas the sector nickel plate had a radius of 80 mm and a vertex angle of 7. 5° to cover 1/48 of the graphite target. The sputtering time was controlled in such a manner as to adjust the thickness of the hard carbon coating to 1.0 ± 0.3 µm.

The surface roughness, composition and sliding characteristics of the thus-obtained hard carbon coating were tested in the same way as in Example 1. The hard carbon coating had a surface roughness Ra of 0.020 µm, a nickel content of 25 atomic% (as measured by XPS), a hydrogen content of 0.1 atomic% or less and a friction coefficient of 0.023, and the opposing member had a sliding mark of 52 µm in diameter.

The coating formation conditions and evaluation test results of Example 2 are also summarized in TABLE.

### Example 3

A hard-carbon coated disk plate was prepared in the same way as in Example 1, except that a hard carbon coating of the disk plate was formed by magnetron sputtering with both of a sector cobalt plate and a sector nickel plate being attached onto a graphite disk target to dope cobalt and nickel into the hard carbon coating of the disk plate. The graphite disk target had a radius of 80 mm, whereas each of the sector cobalt plate and the sector nickel plate had a radius of 80 mm and a vertex angle of 3.75° to cover 1/96 of the graphite target. The sputtering time was controlled in such a manner as to adjust the thickness of the hard carbon coating to 1.0 ± 0.3 µm.

The surface roughness, composition and sliding characteristics of the thus-obtained hard carbon coating were tested in the same way as in Example 1. The hard carbon coating had a surface roughness Ra of 0.015 µm, a cobalt content of 14 atomic%, a nickel content of 11 atomic%, a hydrogen content of 0.1 atomic% or less and a friction coefficient of 0.016, and the opposing member had a sliding mark of 36 µm in diameter.

The coating formation conditions and evaluation test results of Example 3 are also summarized in TABLE.

### Example 4

A hard-carbon coated disk plate was prepared in the same way as in Example 1, except that a hard carbon coating of the disk plate was formed by magnetron sputtering with a sector cobalt plate of smaller size being attached onto a graphite disk target. The graphite disk target had a radius of 80 mm, whereas the sector cobalt plate had a radius of 80 mm and a vertex angle of 1.875° to cover 1/192 of the graphite target. The sputtering time was controlled in such a manner as to adjust the thickness of the hard carbon coating to 1.0 ± 0.3 µm.

The surface roughness, composition and sliding characteristics of the thus-obtained hard carbon coating were tested in the same way as in Example 1. The hard carbon coating had a surface roughness Ra of 0.026 µm, a cobalt content of 3 atomic%, a hydrogen content of 0.1 atomic% or less and a friction coefficient of 0.023, and the opposing member had a sliding mark of 56 µm in diameter.

The coating formation conditions and evaluation test results of Example 4 are also summarized in TABLE.

### Example 5

A hard-carbon coated disk plate was prepared in the same way as in Example 1, except that a hard carbon coating of the disk plate was formed by magnetron sputtering in an atmosphere composed of argon gas and methane gas in proportions of 90:10. The proportion of a cobalt plate to a graphite target used in the magnetron sputtering was 1/48, and the sputtering time was controlled in such a manner as to adjust the thickness of the hard carbon coating to 1.0 ± 0.3 µm.

The surface roughness, composition and sliding characteristics of the thus-obtained hard carbon coating were tested in the same way as in Example 1. The hard carbon coating had a surface roughness Ra of 0.026 µm, a cobalt content of 17 atomic%, a hydrogen content of 7 atomic% and a friction coefficient of 0.039, and the opposing member had a sliding mark of 102 µm in diameter.

The coating formation conditions and evaluation test results of Example 5 are also summarized in TABLE.

### Example 6

A hard-carbon coated disk plate was prepared in the same way as in Example 1, except that a hard carbon coating of the disk plate was formed by magnetron sputtering in an atmosphere composed of argon gas and methane gas in proportions of 98:2. The proportion of a cobalt plate to a graphite target used in the magnetron sputtering was 1/48, and the sputtering time was controlled in such a manner as to adjust the thickness of the hard carbon coating to 1.0 ± 0.3 µm.

The surface roughness, composition and sliding characteristics of the thus-obtained hard carbon coating were tested in the same way as in Example 1. The hard carbon coating had a surface roughness Ra of 0.020 µm, a cobalt content of 18 atomic%, a hydrogen content of 1.4 atomic% and a friction coefficient of 0.036, and the opposing member had a sliding mark of 110 µm in diameter.

The coating formation conditions and evaluation test results of Example 6 are also summarized in TABLE.

### Example 7

A hard-carbon coated disk plate was prepared in the same way as in Example 1, except that a hard carbon coating of the disk plate was formed by magnetron sputtering with a sector cobalt plate of different size being attached onto a graphite disk target. The graphite disk target had a radius of 80 mm, whereas the sector cobalt plate had a radius of 80 mm and a vertex angle of 6° to cover 1/60 of the graphite target. The sputtering time was controlled in such a manner as to adjust the thickness of the hard carbon coating to 1.0 ± 0.3 µm.

The surface roughness, composition and sliding characteristics of the thus-obtained hard carbon coating were tested in the same way as in Example 1. The hard carbon coating had a surface roughness Ra of 0.024 µm, a cobalt content of 15 atomic%, a hydrogen content of 0.1 atomic% or less and a friction coefficient of 0.015, and the opposing member had a sliding mark of 46 µm in diameter.

The coating formation conditions and evaluation test results of Example 7 are also summarized in TABLE.

### Example 8

A hard-carbon coated disk plate was prepared in the same way as in Example 1, except that a hard carbon coating of the disk plate was formed by magnetron sputtering with a sector cobalt plate of different size being attached onto a graphite disk target. The graphite disk target had a radius of 80 mm, whereas the sector cobalt plate had a radius of 80 mm and a vertex angle of 4.5° to cover 1/80 of the graphite target. The sputtering time was controlled in such a manner as to adjust the thickness of the hard carbon coating to 1.0 ± 0.3 µm.

The surface roughness, composition and sliding characteristics of the thus-obtained hard carbon coating were tested in the same way as in Example 1. The hard carbon coating had a surface roughness Ra of 0.022 µm, a cobalt content of 11 atomic%, a hydrogen content of 0.1 atomic% or less and a friction coefficient of 0.012, and the opposing member had a sliding mark of 43 µm in diameter.

The coating formation conditions and evaluation test results of Example 8 are also summarized in TABLE.

### Example 9

A hard-carbon coated disk plate was prepared in the same way as in Example 1, except that a hard carbon coating of the disk plate was formed by magnetron sputtering with a sector cobalt plate of different size being attached onto a graphite disk target. The graphite disk target had a radius of 80 mm, whereas the sector cobalt plate had a radius of 80 mm and a vertex angle of 3° to cover 1/120 of the graphite target. The sputtering time was controlled in such a manner as to adjust the thickness of the hard carbon coating to 1.0 ± 0.3 µm.

The surface roughness, composition and sliding characteristics of the thus-obtained hard carbon coating were tested in the same way as in Example 1. The hard carbon coating had a surface roughness Ra of 0.016 µm, a cobalt content of 7 atomic%, a hydrogen content of 0.1 atomic% or less and a friction coefficient of 0.015, and the opposing member had a sliding mark of 48 µm in diameter.

The coating formation conditions and evaluation test results of Example 9 are also summarized in TABLE.

### Example 10

A hard-carbon coated disk plate was prepared in the same way as in Example 1, except that a hard carbon coating of the disk plate was formed by magnetron sputtering with a cobalt wire being attached onto a graphite disk target along a radius direction thereof to dope a certain amount of cobalt in the hard carbon coating. The graphite disk target had a radius of 80 mm, whereas the cobalt wire had a diameter of 0.5 mm and a length of 80 mm. The sputtering time was controlled in such a manner as to adjust the thickness of the hard carbon coating to 1.0 ± 0.3 µm.

The, surface roughness, composition and sliding characteristics of the thus-obtained hard carbon coating were tested in the same way as in Example 1. The hard carbon coating had a surface roughness Ra of 0.016 µm, a cobalt content of 1.5 atomic%, a hydrogen content of 0.1 atomic% or less and a friction coefficient of 0.026, and the opposing member had a sliding mark of 55 µm in diameter.

The coating formation conditions and evaluation test results of Example 10 are also summarized in TABLE.

### Example 11

A hard-carbon coated disk plate was prepared in the same way as in Example 1, except that a hard carbon coating of the disk plate was formed by magnetron sputtering with a sector cobalt plate of different size being attached onto a graphite disk target. The graphite disk target had a radius of 80 mm, whereas the sector cobalt plate had a radius of 80 mm and a vertex angle of 12° to cover 1/30 of the graphite target. The sputtering time was controlled in such a manner as to adjust the thickness of the hard carbon coating to 1.0 ± 0.3 µm.

The surface roughness, composition and sliding characteristics of the thus-obtained hard carbon coating were tested in the same way as in Example 1. The hard carbon coating had a surface roughness Ra of 0.026 µm, a cobalt content of 34 atomic%, a hydrogen content of 0.1 atomic% or less and a friction coefficient of 0.032, and the opposing member had a sliding mark of 60 µm in diameter.

The coating formation conditions and evaluation test results of Example 11 are also summarized in TABLE.

### Example 12

A hard-carbon coated disk plate was prepared in the same way as in Example 1, except that a hard carbon coating of the disk plate was formed by magnetron sputtering with a sector nickel plate of different size being attached onto a graphite disk target. The graphite disk target had a radius of 80 mm, whereas the sector nickel plate had a radius of 80 mm and a vertex angle of 4.5° to cover 1/80 of the graphite target. The sputtering time was controlled in such a manner as to adjust the thickness of the hard carbon coating to 1.0 ± 0.3 µm.

The surface roughness, composition and sliding characteristics of the thus-obtained hard carbon coating were tested in the same way as in Example 1. The hard carbon coating had a surface roughness Ra of 0.020 µm, a nickel content of 15 atomic%, a hydrogen content of 0.1 atomic% or less and a friction coefficient of 0.014, and the opposing member had a sliding mark of 37 µm in diameter.

The coating formation conditions and evaluation test results of Example 12 are also summarized in TABLE.

### Example 13

A hard-carbon coated disk plate was prepared in the same way as in Example 1, except that a hard carbon coating of the disk plate was formed by magnetron sputtering with a sector nickel plate of different size being attached onto a graphite disk target. The graphite disk target had a radius of 80 mm, whereas the sector nickel plate had a radius of 80 mm and a vertex angle of 3° to cover 1/120 of the graphite target. The sputtering time was controlled in such a manner as to adjust the thickness of the hard carbon coating to 1.0 ± 0.3 µm.

The surface roughness, composition and sliding characteristics of the thus-obtained hard carbon coating were tested in the same way as in Example 1. The hard carbon coating had a surface roughness Ra of 0.021 µm, a nickel content of 8 atomic%, a hydrogen content of 0.1 atomic% or less and a friction coefficient of 0.014, and the opposing member had a sliding mark of 41 µm in diameter.

The coating formation conditions and evaluation test results of Example 13 are also summarized in TABLE.

### Example 14

A hard-carbon coated disk plate was prepared in the same way as in Example 1, except that a hard carbon coating was formed by magnetron sputtering with a nickel wire being attached onto a graphite disk target to dope a certain amount of nickel in the hard carbon coating. The graphite disk target had a radius of 80 mm, whereas the nickel wire had a diameter of 0.5 mm and a length of 80 mm. The sputtering time was controlled in such a manner as to adjust the thickness of the hard carbon coating to 1.0 ± 0.3 µm.

The surface roughness, composition and sliding characteristics of the thus-obtained hard carbon coating were tested in the same way as in Example 1. The hard carbon coating had a surface roughness Ra of 0.016 µm, a nickel content of 1.7 atomic%, a hydrogen content of 0.1 atomic% or less and a friction coefficient of 0.033, and the opposing member had a sliding mark of 62 µm in diameter.

The coating formation conditions and evaluation test results of Example 14 are also summarized in TABLE.

### Example 15

A hard-carbon coated disk plate was prepared in the same way as in Example 1, except that a hard carbon coating of the disk plate was formed by magnetron sputtering with both of a sector cobalt plate and a sector nickel plate being attached onto a graphite disk target to dope cobalt and nickel into the hard carbon coating. The graphite disk target had a radius of 80 mm, whereas each of the sector cobalt plate and the sector nickel plate had a radius of 80 mm and a vertex angle of 3° to cover 1/120 of the graphite target. The sputtering time was controlled in such a manner as to adjust the thickness of the hard carbon coating to 1.0 ± 0.3 µm.

The, surface roughness, composition and sliding characteristics of the thus-obtained hard carbon coating were tested in the same way as in Example 1. The hard carbon coating had a surface roughness Ra of 0.021 µm, a cobalt content of 6 atomic%, a nickel content of 8 atomic%, a hydrogen content of 0.1 atomic% or less and a friction coefficient of 0.011, and the opposing member had a sliding mark of 41 µm in diameter.

The coating formation conditions and evaluation test results of Example 15 are also summarized in TABLE.

### Comparative Example 1

A hard-carbon coated disk plate was prepared in the same way as in Example 1, except that a hard carbon coating of the disk plate was formed by magnetron sputtering using a graphite disk of 80 mm in radius solely as a sputtering target so as to make the hard carbon coating substantially free of cobalt and nickel. The sputtering time was controlled in such a manner as to adjust the thickness of the hard carbon coating to 1.0 ± 0.3 µm.

The surface roughness, composition and sliding characteristics of the thus-obtained hard carbon coating were tested in the same way as in Example 1. The hard carbon coating had a surface roughness Ra of 0.020 µm, a cobalt content of 0.1 atomic% or less, a nickel content of 0.1 atomic% or less, a hydrogen content of 0.1 atomic% or less and a friction coefficient of 0.055, and the opposing member had a sliding mark of 220 µm in diameter.

The coating formation conditions and evaluation test results of Comparative Example 1 are also summarized in TABLE.

### Comparative Example 2

A hard-carbon coated disk plate was prepared in the same way as in Example 1, except that a hard carbon coating of the disk plate was formed by magnetron sputtering with a sector cobalt plate of larger size being attached onto a graphite disk target. The graphite disk target had a radius of 80 mm, whereas the sector cobalt plate had a radius of 80 mm and a vertex angle of 15° to cover 1/24 of the graphite target. The sputtering time was controlled in such a manner as to adjust the thickness of the hard carbon coating to 1.0 ± 0.3 µm.

The surface roughness, composition and sliding characteristics of the thus-obtained hard carbon coating were tested in the same way as in Example 1. The hard carbon coating had a surface roughness Ra of 0.030 µm, a cobalt content of 40 atomic%, a hydrogen content of 0.1 atomic% or less and a friction coefficient of 0.046, and the opposing member had a sliding mark of 100 µm in diameter.

The coating formation conditions and evaluation test results of Comparative Example 2 are also summarized in TABLE.

### Comparative Example 3

A hard-carbon coated disk plate was prepared in the same way as in Example 1, except that a hard carbon coating of the disk plate was formed by magnetron sputtering with a sector palladium plate being attached onto a graphite disk target to dope a certain amount of palladium into the hard carbon coating. The graphite disk target had a radius of 80 mm, whereas the sector palladium plate had a radius of 80 mm and a vertex angle of 3.75° to cover 1/96 of the graphite target. The sputtering time was controlled in such a manner as to adjust the thickness of the hard carbon coating to 1.0 ± 0.3 µm.

The surface roughness, composition and sliding characteristics of the thus-obtained hard carbon coating were tested in the same way as in Example 1. The hard carbon coating had a surface roughness Ra of 0.023 µm, a palladium content of 7 atomic% (as measured by XPS), a hydrogen content of 0.1 atomic% or less and a friction coefficient of 0.024, and the opposing member had a sliding mark of 270 µm in diameter.

The coating formation conditions and evaluation test results of Comparative Example 3 are also summarized in TABLE.

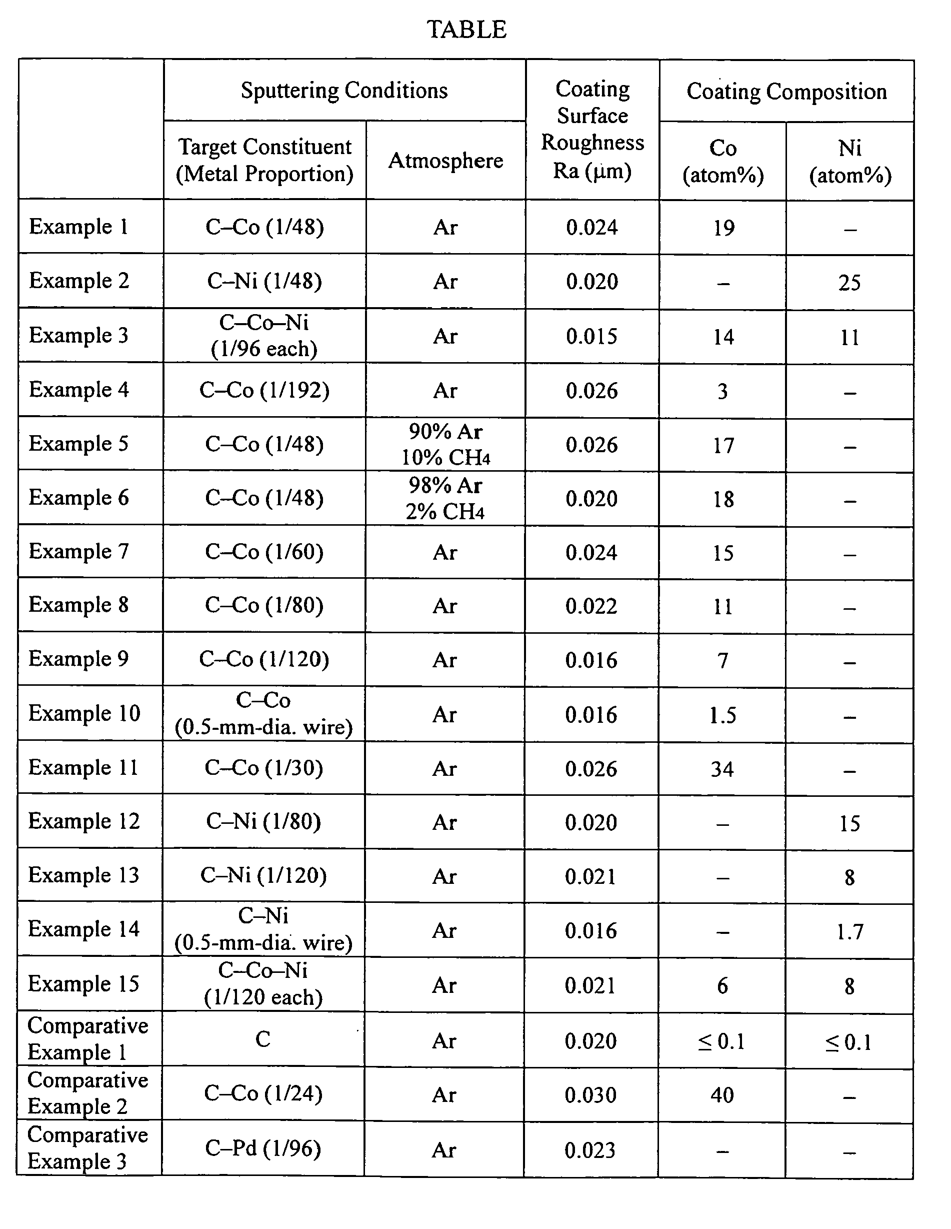

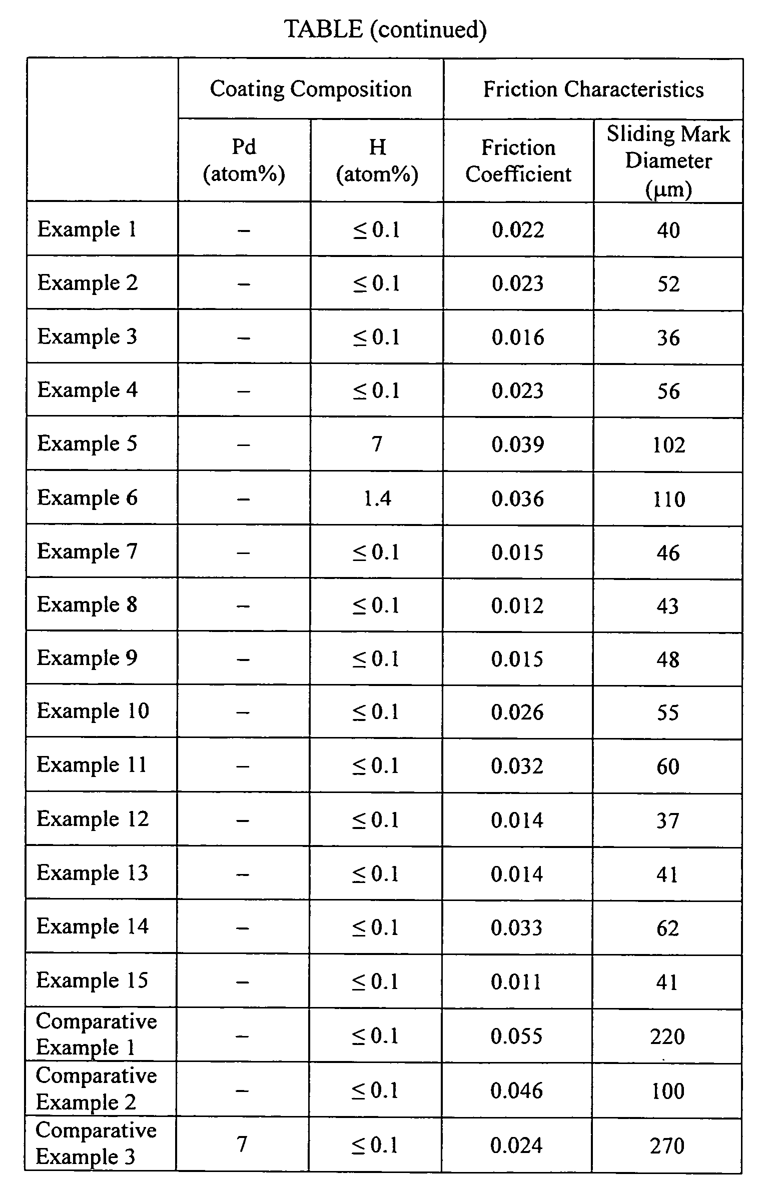

As is apparent from TABLE, the hard carbon coating of Comparative Example 1 substantially free of cobalt and nickel was high in friction coefficient and abrasiveness. It is also apparent from TABLE that the hard carbon coating of Comparative Example 2 having a hydrogen content of more than 39 atomic% was particularly high in friction coefficient and the hard carbon coating of Comparative Example 3 doped with palladium was high in abrasiveness.

On the other hand, the hard carbon coatings of Examples 1-15 each containing a cobalt and/or nickel content of 1.4 to 39 atomic% were low in friction coefficient and abrasiveness. The hard carbon coatings of Examples 1-4 and 7-15 each having a hydrogen content of 0.1 atomic% or less, in particular, showed excellent low-friction sliding characteristics. Further, the hard carbon coatings were made lower in friction coefficient and abrasiveness by controlling the cobalt and/or nickel amounts of the hard carbon coatings to within the range of 3 to 20 atomic%, preferably 6 to 16 atomic%, as is apparent from the comparisons of Examples 1-4 and 7-15. Example 15 is thus considered especially favorable because of its lowest friction coefficient and relatively low abrasiveness of the hard carbon coating. Examples 8, 12 and 13 are also considered favorable among those having hard carbon coatings doped with either cobalt or nickel.

Although the amount of cobalt and/or nickel in the hard carbon coating was adjusted by changing the area proportion of the cobalt and/or nickel plate to the target graphite in the above examples, the cobalt and/or nickel amount of the hard carbon coating can be adjusted by any other method.

The entire contents of Japanese Patent Application No. 2004-317513 (filed on November 1, 2004) and No. 2005-088270 (filed on March 25, 2005) are herein incorporated by reference.

Although the present invention has been described with reference to the specific embodiments of the invention, the invention is not limited to the above-described embodiments. Various modification and variation of the embodiments described above will occur to those skilled in the art in light of the above teaching. The scope of the invention is defined with reference to the following claims.

## Claims

1. A sliding member (1), comprising:
a base substrate (2); and
a hard carbon coating (3) formed on the base substrate (2) to define at least a surface for sliding contact with an opposing sliding member, the hard carbon coating (3) containing therein at least one of cobalt and nickel in an amount of 1.4 to 39 atomic%.

2. The sliding member (1) according to Claim 1, wherein the amount of said at least one of cobalt and nickel contained in the hard carbon coating (3) is 3 to 20 atomic%.

3. The sliding member (1) according to Claim 2, wherein the amount of said at least one of cobalt and nickel contained in the hard carbon coating (3) is 6 to 16 atomic%.

4. The sliding member (1) according to any one of Claims 1 to 3, wherein the hard carbon coating (3) further contains hydrogen in an amount of 6 atomic% or less.

5. The sliding member (1) according to Claim 4, wherein the amount of said hydrogen contained in the hard carbon coating (3) is 1 atomic% or less.

6. The sliding member (1) according to any one of Claims 1 to 5, wherein said sliding contact surface is lubricated with a lubricating oil.

7. The sliding member (1) according to Claim 6, wherein the lubricating oil is an automotive engine oil.

8. The sliding member (1) according to Claim 6, wherein the lubricating oil is an automotive transmission oil.

9. A sliding member (1), comprising:
a base substrate (2); and
a hard carbon coating (3) formed on the base substrate (2) to define at least a surface for sliding contact with an opposing member,
wherein at least an outermost surface portion of the hard carbon coating (3) comprises 1.4 to 39 atomic% of either or both of cobalt and nickel, 6 atomic% or less of hydrogen and the balance being carbon.

10. The sliding member (1) according to Claim 9, wherein the amount of said either or both of cobalt and nickel in the surface portion of the hard carbon coating (3) is 3 to 20 atomic%.

11. The sliding member (1) according to Claim 10, wherein the amount of said either or both of cobalt and nickel in the surface portion of the hard carbon coating (3) is 6 to 16 atomic%.

12. The sliding member (1) according to any one of Claims 9 to 11, wherein the amount of said hydrogen in the surface portion of the hard carbon coating (3) is 1 atomic% or less.

13. The sliding member (1) according to any one of Claims 9 to 12, further comprising a lubricating oil applied to said sliding contact surface.

14. The sliding member (1) according to Claim 13, wherein the lubricating oil is an automotive engine oil or transmission oil.

15. The sliding member (1) according to any one of Claims 9 to 14, wherein the hard carbon coating (3) is formed by physical vapor deposition.
